# EUROPEAN PATENT SPECIFICATION

(11) **EP 4 462 142 B1**
(45) Date of publication and mention of the grant of the patent: **29.04.2026**
(21) Application number: 23771071.0
(22) Date of filing: 14.03.2023
(51) Int. Cl.: G01R 31/36, B60L 3/00, B60L 3/04, B60L 58/19, B60L 58/21, G01R 31/327

(54) **BATTERY SYSTEM CAPABLE OF PACK RELAY DIAGNOSIS AND VEHICLE COMPRISING THE SAME**
BATTERIESYSTEM MIT BATTERIEPACKS-RELAIS DIAGNOSEFUNKTION UND FAHRZEUG MIT EINEM SOLCHEN BATTERIESYSTEM
SYSTÈME DE BATTERIE AVEC FONCTION DE DIAGNOSTIC DU RELAIS DE BATTERIE ET VÉHICULE ÉQUIPÉ D'UN TEL SYSTÈME DE BATTERIE

(30) Priority: 16.03.2022 KR 20220032752
(43) Date of publication of application: 13.11.2024
(73) Proprietor: LG Energy Solution, Ltd., Seoul 07335 (KR)
(72) Inventor: RYU, Jesung, Daejeon 34122 (KR)
(74) Representative: Plasseraud IP
(86) International application number: PCT/KR2023/003426
(87) International publication number: WO 2023/177192

(56) References cited:
- EP-B1- 2 768 689
- JP-A- 2017 102 026
- JP-B2- 6 673 035
- KR-A- 20090 011 497
- KR-A- 20090 011 497
- KR-A- 20130 092 350
- KR-A- 20190 072 764
- KR-A- 20210 152 637
- US-A1- 2017 160 334
- US-A1- 2019 237 816

## Description

### [Technical Field]

### CROSS-REFERENCE TO RELATED APPLICATION

This application claims priority to and the benefit of Korean Patent Application No. 10-2022-0032752 filed in the Korean Intellectual Property Office on March 16, 2022.

The present disclosure relates to a battery system capable of diagnosing a pack relay and a vehicle including the same.

### [Background Art]

A battery system may include a plurality of battery packs connected in parallel to a junction box. Power may be supplied to a vehicle from a plurality of battery packs through the junction box. As the number of battery packs connected in parallel increases, the battery system may supply more power. Each of the plurality of battery packs includes a pack relay connected to the junction box and a pack battery management system (hereinafter referred to as a pack BMS) that controls an operation of the pack relay. When the relays of each of the plurality of battery packs are closed and the relay of the junction box is closed, power may be supplied to the vehicle from each of the battery packs.

After the pack BMS wakes up, the pack BMS controls the pack relay to be closed. Thereafter, the pack BMS determines whether the pack relay is normally closed. Hereinafter, an operation of determining whether the pack relay is normally closed is referred to as pack relay diagnosis.

Specifically, the pack BMS measures voltages at both ends of the pack relay, respectively, and compares the voltages at both ends thereof, respectively, to diagnose the pack relay. However, since one end of the plurality of pack relays is connected to the junction box through one link bus bar, the voltage of one end of the pack relay that is not closed among the plurality of pack relays may be similar to that of the battery pack. According to the conventional methods for solving such a problem, the time required for diagnosing the pack relay is considerable.

Even when performing the pack relay diagnosis sequentially for the plurality of pack relays one by one, the considerable time is required.

Document EP 2 768 689 discloses battery packs and systems and methods for diagnosing welding of one or more electrical contactors of the related art.

### [Disclosure]

### [Technical Problem]

The present disclosure attempts to provide a battery system capable of diagnosing a pack relay capable of reducing a time required for diagnosing a plurality of pack relays, and a vehicle including the same.

### [Technical Solution]

According to an aspect of the present disclosure, a battery system is defined in the appended claims.

According to another aspect of the present disclosure, a vehicle is also provided.

### [Advantageous Effects]

According to the present disclosure, it is possible to provide a battery system capable of diagnosing a pack relay capable of reducing a time required for diagnosing a plurality of pack relays, and a vehicle including the same

### [Description of the Drawings]

FIG. 1 is a diagram schematically illustrating a battery system and a vehicle including the battery system according to an embodiment.
FIG. 2 is a flowchart illustrating a method of diagnosing a pack relay according to an exemplary embodiment.
FIG. 3 is a diagram schematically illustrating a battery system and a vehicle including the battery system according to another exemplary embodiment.

### [Mode for Invention]

Hereafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. Further, when it is decided that a detailed description for the known art related to the present disclosure may obscure the gist of the present disclosure, the detailed description will be omitted.

Terms including an ordinal number such as first, second, etc., may be used to describe various components, but the components are not limited to these terms. The terms are used only to distinguish one component from another component.

Further, in the present specification, it is to be understood that when one component is referred to as being "connected to" or "coupled to" another component, it may be connected or coupled directly to another component or be connected to another component with the other component interposed therebetween. On the other hand, it should be understood that when one element is referred to as being "connected directly to" or "coupled directly to" another element, it may be connected to or coupled to another element without the other element interposed therebetween.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

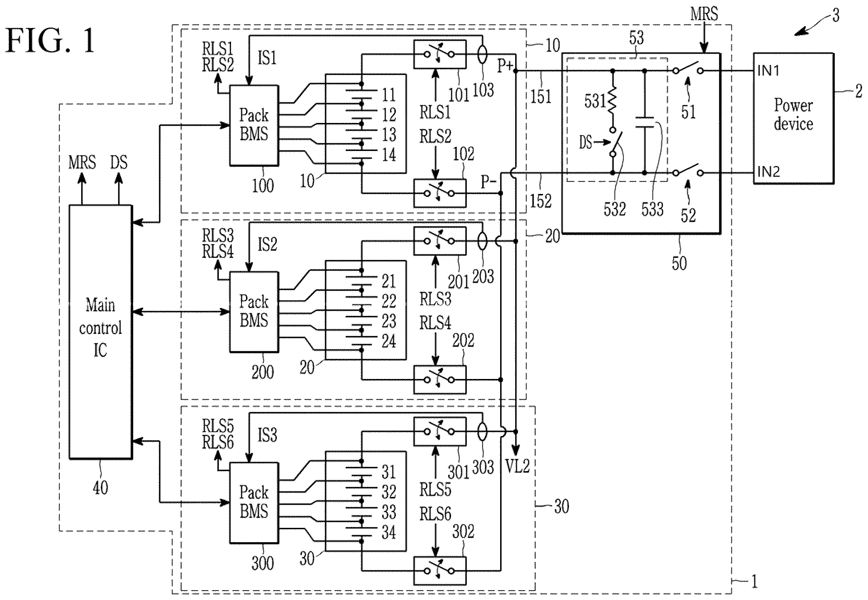

FIG. 1 is a diagram schematically illustrating a battery system and a vehicle including the battery system according to an embodiment.

A vehicle 3 includes a battery system 1 and a power device 2. In an exemplary embodiment, a vehicle is taken as an example of a device to which the battery system 1 is applied, but the present disclosure is not limited thereto. The vehicle 3 includes, for example, a hybrid vehicle or the like that is driven only by a motor without an internal combustion engine or includes both an internal combustion engine and a motor.

The battery system 1 includes a plurality of battery packs 10 to 30, a main control integrated circuit (IC) 40, and a junction device 50. Although the number of battery packs is illustrated in FIG. 1 as three, the present disclosure is not limited thereto and the battery system 1 may include four or more battery packs. In addition, although the plurality of battery packs 10 to 30 are illustrated in parallel in FIG. 1, two or more battery packs may be connected in series, and a plurality of battery packs connected in series may be connected in parallel.

The power device 2 may be a load receiving power from the battery system 1 or a charger for charging the battery system 1. For example, the power device 2 may include at least one of an inverter, a DC-DC converter, a motor, an electronic control circuit, an on board charger (OBC), and a fast charger of the vehicle 3. The power device 2 includes two input terminals IN1 and IN2.

The plurality of battery packs 10 to 30 are connected in parallel to each other, and both ends of the plurality of battery packs 10 to 30 are each connected to the junction device 50 through wirings 151 and 152, respectively.

The junction device 50 includes a first main relay 51 connected between the wiring 151 and an input terminal IN1 of the power device 2, and a second main relay 52 connected between the wiring 152 and an input terminal IN2 of the power device 2. The first and second main relays 51 and 52 may control the connection between the plurality of battery packs 10 to 30 and the power device 2, and the main control IC 40 may control operations of the first and second main relays 51 and 52 to generate a relay control signal (MRS) and transmit the generated relay control signal to the junction device 50.

The junction device 50 may control the opening and closing of the first and second main relays 51 and 52 according to the relay control signal MRS. Although the junction device 50 is illustrated as including a pair of main relays in FIG. 1, the number of main relay pairs may be determined according to the number of configurations of the power device 2.

In an exemplary embodiment, the junction device 50 further includes a diagnostic circuit 53. The diagnostic circuit 53 includes a resistor 531, a switch 532, and a capacitor 533.

One end of the resistor 531 is connected to the wiring 151, the other end of the resistor 531 is connected to one end of the switch 532, and the other end of the switch 532 is connected to the wiring 152. One end of the capacitor 533 is connected to the wiring 151, and the other end of the capacitor 533 is connected to the wiring 152. The switch 532 may perform a switching operation according to a discharge signal DS transmitted from the main control device 40. In the junction device 50, the diagnostic circuit 53 needs to be connected between the first main relay 51 and the second main relay 52 and the plurality of relays 101, 102, 201, 202, 301 and 302. The main control IC 40 may control the first and second main relays 51 and 52 to be open during a pack relay diagnosis period for the plurality of relays 101, 102, 201, 202, 301, and 302.

Unlike what is illustrated in FIG. 1, the diagnostic circuit 53 may be implemented as a separate configuration separated from the junction device 50. Even in this case, the diagnostic circuit 53 needs to be connected between the junction device 50 and the plurality of relays 101, 102, 201, 202, 301, and 302.

The plurality of battery packs 10 to 30 include a plurality of battery cells 11 to 14, 21 to 24, and 31 to 34, the plurality of pack battery management systems 100, 200, and 300, the plurality of relays 101, 102, 201, 202, 301, and 302, and a plurality of current sensors 103, 203, 303. Hereinafter, the pack battery management system is referred to as a pack battery management system (pack BMS). In FIG. 1, each of the plurality of battery packs 10 to 30 is illustrated as including the four battery cells 11 to 14, 21 to 24, and 31 to 34, but this is an example and the present disclosure is not limited thereto. In addition, each of the plurality of battery packs 10 to 30 is illustrated as including two relays, but this is an example, and the number of relays may be at least one.

Each of the plurality of pack BMSs 100, 200, and 300 is connected to a plurality of corresponding battery cells 11 to 14, 21 to 24, and 31 to 34, and measures cell voltages of the plurality of battery cells 11 to 14, 21 to 24, and 31 to 34. Each of the plurality of pack BMSs 100, 200, and 300 may acquire a voltage (hereinafter, battery pack voltage), a current (hereinafter, battery pack current), and a temperature (hereinafter, temperature of battery pack) of each of the corresponding battery packs 10, 20, and 30. Each of the plurality of pack BMSs 100, 200 and 300 may control the charging and discharging of the battery packs 10 to 30 based on the cell voltages of the plurality of corresponding battery cells 11 to 14, 21 to 24, and 31 to 34, the battery pack current, and the like, and control and perform a cell balancing operation for the plurality of battery cells 11 to 14, 21 to 24, and 31 to 34.

The plurality of pack BMSs 100, 200, and 300 open and close each of the plurality of relays 101, 102, 201, 202, 301, and 302 to control the charging and discharging of the plurality of battery packs 10 to 30. The relay 101 is connected between a positive electrode of the battery pack 10 and a node P+, and the relay 102 is connected between an negative electrode of the battery pack 10 and a node P-. The relay 201 is connected between the positive electrode of the battery pack 20 and the node P+, and the relay 202 is connected between the negative electrode of the battery pack 20 and the node P-. The relay 301 is connected between the positive electrode of the battery pack 30 and the node P+, and the relay 302 is connected between the negative electrode of the battery pack 30 and the node P-.

Each of the plurality of pack BMSs 100, 200, and 300 may control the opening and closing of the corresponding two relays 101/102, 201/202, and 301/302 to generate two drive signals RLS1/RLS2, RLS3/RLS4, and RLS5/RLS6 and supply the generated drive signals RLS1/RLS2, RLS3/RLS4, and RLS5/RLS6 to the corresponding two relays 101/102, 201/202, and 301/302.

The main control IC 40 may receive the information on the cell voltages of the plurality of battery cells 11-15, 21-25, and 31-35 from the plurality of pack BMSs 100, 200, and 300, the battery pack voltage for the plurality of battery packs 10, 20, and 30, the battery pack current, and the battery pack temperature, and the like. The main control IC 40 may supply a power control signal to the plurality of pack BMSs 100, 200, and 300 to supply power to the outside, or may supply a charging control signal to the plurality of pack BMSs 100, 200, and 300 to charge the plurality of battery packs 10, 20, and 30. In addition, the main control IC 40 may perform control necessary for the operation of the battery system 1 and start and perform control by performing a protection operation when an abnormal state of the battery system 1 is detected.

Each of the plurality of current sensors 103, 203, and 303 may measure the battery pack current to transmit signals (hereinafter, current detection signals) IS1, IS2, and IS3 instructing the measured current to each of the plurality of pack BMSs 100, 200, and 300.

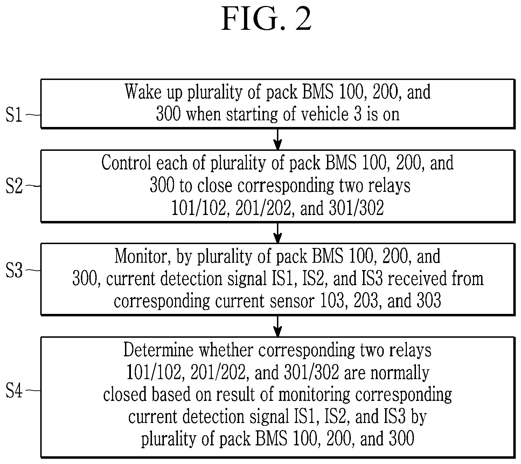

FIG. 2 is a flowchart illustrating a method of diagnosing a pack relay according to an exemplary embodiment.

When the starting of the vehicle 3 is on, the plurality of pack BMSs 100, 200, and 300 wake up (S1). After waking up, the plurality of pack BMSs 100, 200, and 300 may determine whether the plurality of relays 101/102, 201/202, and 301/302 are normally closed.

After waking up, each of the plurality of pack BMSs 100, 200, and 300 controls to close the corresponding two relays 101/102, 201/202, and 301/302 (S2).

Each of the plurality of pack BMSs 100, 200, and 300 may monitor the current detection signals IS1, IS2, and IS3 received from the corresponding current sensors 103, 203, and 303 after controlling the corresponding two relays 101/102, 201/202, and 301/302 to be closed (S3).

Each of the plurality of pack BMSs 100, 200, and 300 may determine whether the corresponding two relays 101/102, 201/202, and 301/302 are normally closed based on the results of monitoring the corresponding current detection signals IS1, IS2, and IS3 (S4). The first and second main relays 51 and 52 of the junction device 50 are in an open state during a period in which the states of the two relays 101/102, 201/202, and 301/302 corresponding to each of the plurality of pack BMSs 100, 200, and 300 are diagnosed.

Immediately after waking up, when the corresponding two relays 101/102, 201/202, and 301/302 are normally closed, a current flows from the corresponding battery packs 10, 20, and 30 to a capacitor 533, and the corresponding current sensors 103, 203, and 303 may detect the current.

For example, the two relays 101 and 102 receive relay control signals RLS1 and RLS2 instructing closing from the pack BMS 100. When two relays 101 and 102 are normally closed, a current flows from the battery pack 10 to the capacitor 533, and the current sensor 103 detects a current flowing to the capacitor 533 and generates the current detection signal IS1. The current detection signal IS1 is transmitted to the pack BMS 100, and the pack BMS 100 determines that two relays 101 and 102 are normally closed based on the current sensing signal IS1. When at least one of the two relays 101 and 102 is in a stuck open state, at least one of the two relays 101 and 102 is not closed despite the closing control. Then, no current flows from the battery pack 10 to the capacitor 533. The pack BMS 100 may determine that at least one of the two relays 101 and 102 is in the stuck open state when the current detection signal IS1 received from the current sensor 103 indicates zero current.

The two relays 201 and 202 receive the relay control signals RLS3 and RLS4 instructing closing from the pack BMS 200. When two relays 201 and 202 are normally closed, a current flows from the battery pack 20 to the capacitor 533, and the current sensor 203 detects the current flowing to the capacitor 533 and generates the current detection signal IS2. The current detection signal IS2 is transmitted to the pack BMS 200, and the pack BMS 200 determines that two relays 201 and 202 are normally closed based on the current sensing signal IS2. When at least one of the two relays 201 and 202 is in the stuck open state, at least one of the two relays 201 and 202 is not closed despite the closing control. Then, no current flows from the battery pack 20 to the capacitor 533. The pack BMS 200 may determine that at least one of the two relays 201 and 202 is in the stuck open state when the current detection signal IS2 received from the current sensor 203 indicates zero current.

The two relays 301 and 302 receive the relay control signals RLS3 and RLS4 instructing closing from the pack BMS 300. When two relays 301 and 302 are normally closed, a current flows from the battery pack 30 to the capacitor 533, and the current sensor 303 detects a current flowing to the capacitor 533 and generates the current detection signal IS3. The current detection signal IS3 is transmitted to the pack BMS 300, and the pack BMS 300 determines that two relays 301 and 302 are normally closed based on the current sensing signal IS3. When at least one of the two relays 301 and 302 is in the stuck open state, at least one of the two relays 301 and 302 is not closed despite the closing control. Then, no current flows from the battery pack 30 to the capacitor 533. The pack BMS 300 may determine that at least one of the two relays 303 and 301 is in the stuck open state when the current detection signal IS3 received from the current sensor 302 indicates zero current.

The plurality of pack BMSs 100, 200, and 300 may wake up simultaneously when the operation of the battery system 1 starts. When the operation of the battery system 1 ends, the main control IC 40 generates a discharge signal DS to turn on the switch 532 for a predetermined discharge period. Then, the capacitor 533 can be discharged through the resistor 531 and the switch 532. The predetermined discharge period may be set to a time sufficient for the capacitor 533 to be discharged to zero voltage. The operation of the battery system 1 may start when the starting of the vehicle 3 is on, and may end when the starting of the vehicle 3 is off. The operation of the battery system 1 may include a discharging operation for supplying power and a charging operation for receiving power.

Each of the plurality of pack BMSs 100, 200, and 300 may notify the main control IC 40 that the diagnosis result of the corresponding two relays is in the stuck open state. The main control IC 40 may keep the first and second relays 51 and 52 open when there is a stuck-open relay among the plurality of relays 101, 102, 201, 202, 301, and 302. The main control IC 40 controls the first and second relays 51 and 52 of the junction device 50 to be closed when all of the plurality of relays 101, 102, 201, 202, 301, and 302 are in a normal state. The main control IC 40 may generate an off-level relay control signal MRS and transmit the generated off-level relay control signal to the junction device 50 in order to control the first and second main relays 51 and 52 to be in the open state. The main control IC 40 may generate an on-level relay control signal MRS and transmit the generated on-level relay control signal to the junction device 50 in order to control the first and second main relays 51 and 52 to be in the closed state.

In FIG. 1, it is shown that the capacitor 533 is directly connected between the wiring 151 and the wiring 153, but the present disclosure is not limited thereto.

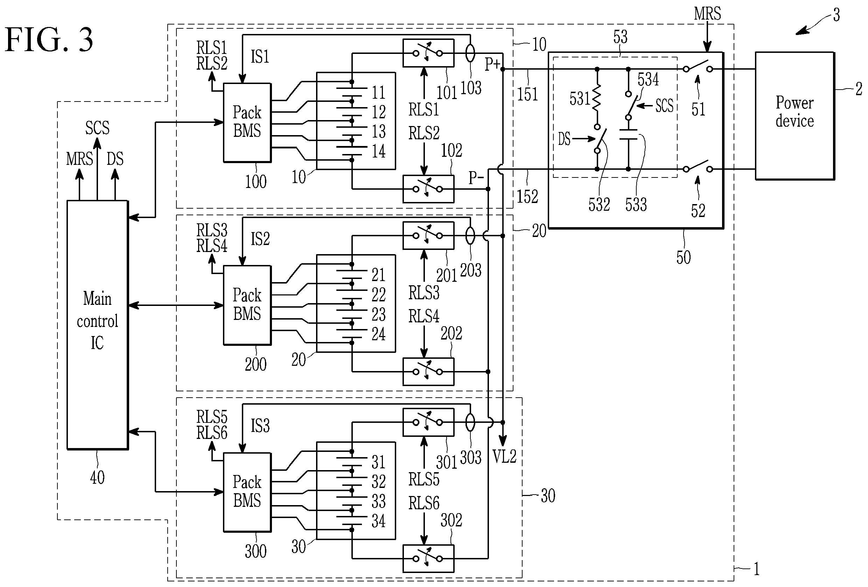

FIG. 3 is a diagram schematically illustrating a battery system and a vehicle including the battery system according to another exemplary embodiment.

Among the components illustrated in FIG. 3, descriptions of components identical to those illustrated in FIG. 1 will be omitted. As illustrated in FIG. 3, the diagnostic circuit 53 may further include a connection switch 534 connected between one of the wiring 151 and wiring 152 and the capacitor 533. For example, a connection switch 534 may be connected between the capacitor 533 and the wiring 151. One end of the connection switch 534 is connected to the wiring 151, an end of the capacitor 533 is connected to the other end of the connection switch 534, and the other end of the capacitor 533 is connected to the wiring 152. The connection switch 534 may perform a switching operation according to a switch control signal (SCS).

The main control IC 40 may control the connection switch 534 to be in an on state during the diagnosis period for the two relays corresponding to the plurality of pack BMSs 100, 200, and 300, respectively, and when the diagnosis period ends, control the connection switch 534 to be in an off state. To this end, the main control IC 40 may further generate the switch control signal (SCS). The main control IC 40 may generate the on-level switch control signal (SCS) during the diagnosis period and generate the off-level switch control signal (SCS) when the diagnosis period ends. After the diagnosis period ends, the connection switch 534 is turned off, and the capacitor 533 may not be involved in the operation of the battery system 1 other than the diagnosis operation.

Although the embodiments of the present disclosure have been described in detail above, the scope of the present disclosure is not limited thereto, and various modifications and improvements by those of ordinary skill in the field to which the present disclosure pertains belong to the scope of the present disclosure.

## Claims

1. A battery system (1), comprising:
a plurality of battery packs (10, 20, 30), each battery pack (10, 20, 30) having a positive electrode and a negative electrode;
a first common node (P+) and a second common node (P-);
a plurality of first relays (101, 201, 301), each first relay (101, 201, 301) connected between the positive electrode of a corresponding one of the plurality of battery packs (10, 20, 30) and the first common node (P+);
a plurality of second relays (102, 202, 302), each second relay (102, 202, 302) connected between the negative electrode of a corresponding one of the plurality of battery packs (10, 20, 30) and the second common node (P-) ;
a capacitor (533) having both ends connected between the first common node (P+) and the second common node (P-);
a resistor (531) and a switch (532) connected in series between the first common node (P+) and the second common node (P-);
a plurality of current sensors (103, 203, 303), each current sensor (103, 203, 303) configured to detect a current flowing from a corresponding one of the plurality of battery packs (10, 20, 30); and
a plurality of pack battery management systems, BMS, (100, 200, 300), each battery management system (100, 200, 300) being associated with a respective one of the plurality of battery packs (10, 20, 30), its corresponding first relay (101, 201, 301) and second relay (102, 202, 302), and its corresponding current sensor (103, 203, 303);
wherein each battery management system (100, 200, 300) is configured to, after waking up and controlling its corresponding first relay (101, 201, 301) and its corresponding second relay (102, 202, 302) to be closed, determine that its corresponding first (101, 201, 301) and second (102, 202, 302) relays are normal when a current flowing from its corresponding battery pack (10, 20, 30) to the capacitor (533) is detected by its corresponding current sensor (103, 203, 303).

2. The battery system of claim 1, wherein:
each of the plurality of battery management systems (100, 200, 300)
receives a current sensing signal from its corresponding current sensor (103, 203, 303) among the plurality of current sensors (103, 203, 303), and when the received current sensing signal indicates a zero current after its corresponding first (101, 201, 301) and second (102, 202, 302) relays have been controlled to be closed, diagnoses that at least one of its corresponding first (101, 201, 301) and second (102, 202, 302) relays is in a stuck open state.

3. The battery system of claim 1, further comprising:
a main control IC (40) discharging the capacitor (533) by turning on the switch (532) for a predetermined discharging period when an operation of the battery system ends.

4. The battery system of claim 1, further comprising:
a first main relay (51) connected between a first input terminal of a power device (2) connected to the battery system and positive electrodes of the plurality of battery packs (10, 20, 30); and
a second main relay (52) connected between a second input terminal of the power device (2) and negative electrodes of the plurality of battery packs (10, 20, 30);
wherein the capacitor (533), the resistor (531), and the switch (532)
are positioned between the first main relay (51) and the second main relay (52), and between the plurality of first relays (101, 201, 301) and the plurality of second relays (102, 202, 302).

5. The batter system of claim 4, wherein:
the first main relay (51) and the second main relay (52)
are controlled to be in an open state during a period in which the diagnosis is performed on the plurality of first relays (101, 201, 301) and the plurality of second relays (102, 202, 302).

6. The battery system of claim 4, further comprising:
a connection switch (534) connected between any one of a first wiring (151) and a second wiring (152) connecting the first common node (P+) and the second common node (P-) to the power device (2) and the capacitor (533).

7. A vehicle, comprising:
a battery system (1) according to claim 1; and
a power device (2) that is a load receiving power from the battery system (1) or a charger for charging the battery system.

8. The vehicle of claim 7, wherein:
each of the plurality of battery management system (100, 200, 300)
receives a current sensing signal from its corresponding current sensor (103, 203, 303) among the plurality of current sensors (103, 203, 303), and when the received current sensing signal indicates a zero current after its corresponding first (101, 201, 301) and second (102, 202, 302) relays have been controlled to be closed, diagnoses that at least one of the corresponding first (101, 201, 301) and second (102, 202, 302) relays is in a stuck open state.

9. The vehicle of claim 7, wherein:
the battery system (1) further includes
a main control IC (40) discharging the capacitor (533) by turning on the switch (532) for a predetermined discharging period when starting of the vehicle is off.

10. The vehicle of claim 7, further comprising:
a first main relay (51) connected between a first input terminal of the power device (2) and positive electrodes of the plurality of battery packs (10, 20, 30); and
a second main relay (52) connected between a second input terminal of the power device (2) and negative electrodes of the plurality of battery packs (10, 20, 30),
wherein the capacitor (533), the resistor (531), and the switch (532)
are positioned between the first main relay (51) and the second main relay (52), and between the plurality of first relays (101, 201, 301) and the plurality of second relays (102, 202, 302).

11. The vehicle of claim 10, wherein:
the battery system (1)
controls the first main relay (51) and the second main relay (52) to be open during a period in which diagnosis is performed on the plurality of first relays (101, 201, 301) and the plurality of second relays (102, 202, 302).

12. The vehicle of claim 7, wherein:
the battery system (1)
further includes a connection switch (534) connected between any one of a first wiring (151) and a second wiring (152) connecting the first common node (P+) and the second common node (P-) to the power device (2) and the capacitor (533).

## Patentansprüche

1. Batteriesystem (1), umfassend:
eine Mehrzahl von Batteriepacks (10, 20, 30), wobei jeder Batteriepack (10, 20, 30) eine positive Elektrode und eine negative Elektrode aufweist;
einen ersten gemeinsamen Knoten (P+) und einen zweiten gemeinsamen Knoten (P-);
eine Mehrzahl erster Relais (101, 201, 301), wobei jedes erste Relais (101, 201, 301) zwischen der positiven Elektrode eines entsprechenden der Mehrzahl von Batteriepacks (10, 20, 30) und dem ersten gemeinsamen Knoten (P+) geschaltet ist;
eine Mehrzahl zweiter Relais (102, 202, 302), wobei jedes zweite Relais (102, 202, 302) zwischen der negativen Elektrode eines entsprechenden der Mehrzahl von Batteriepacks (10, 20, 30) und dem zweiten gemeinsamen Knoten (P-) geschaltet ist;
einen Kondensator (533), dessen beider Enden zwischen dem ersten gemeinsamen Knoten (P+) und dem zweiten gemeinsamen Knoten (P-) geschaltet sind;
einen Widerstand (531) und einen Schalter (532), welche zwischen dem ersten gemeinsamen Knoten (P+) und dem zweiten gemeinsamen Knoten (P-) in Reihe geschaltet sind;
eine Mehrzahl von Stromsensoren (103, 203, 303), wobei jeder Stromsensor (103, 203, 303) dazu eingerichtet ist, einen Strom zu detektieren, welcher von einem entsprechenden der Mehrzahl von Batteriepacks (10, 20, 30) strömt; und
eine Mehrzahl von Pack-Batterie-Management-Systemen (BMS) (100, 200, 300), wobei jedes Batterie-Management-System (100, 200, 300) einem jeweiligen der Mehrzahl von Batteriepacks (10, 20, 30), seinem entsprechenden ersten Relais (101, 201, 301) und zweiten Relais (102, 202, 302) und seinem entsprechenden Stromsensor (103, 203, 303) zugeordnet ist;
wobei jedes Batterie-Management-System (100, 200, 300) dazu eingerichtet ist, nach einem Aufwachen und einem Steuern seines entsprechenden ersten Relais (101, 201, 301) und seines entsprechenden zweiten Relais (102, 202, 302) geschlossen zu sein, zu bestimmen, dass seine entsprechenden ersten (101, 201, 301) und zweiten (102, 202, 302) Relais normal sind, wenn ein Strom, welcher von seinem entsprechenden Batteriepack (10, 20, 30) zu dem Kondensator (533) strömt, durch seinen entsprechenden Stromsensor (103, 203, 303) detektiert wird.

2. Batteriesystem nach Anspruch 1, wobei:
jedes der Mehrzahl der Batterie-Management-Systemen (100, 200, 300) ein Stromerfassungssignal von seinem entsprechenden Stromsensor (103, 203, 303) unter der Mehrzahl von Stromsensoren (103, 203, 303) empfängt und, wenn das empfangene Stromerfassungssignal einen Nullstrom anzeigt, nachdem seine entsprechenden ersten (101, 201, 301) und zweiten (102, 202, 302) Relais gesteuert worden sind, um geschlossen zu sein, diagnostiziert, dass wenigstens eines seiner entsprechenden ersten (101, 201, 301) und zweiten (102, 202, 302) Relais in einem bleibenden geöffneten Zustand ist.

3. Batteriesystem nach Anspruch 1, ferner umfassend:
eine Hauptsteuerungs-IC (40), welche den Kondensator (533) durch Einschalten des Schalters (532) für einen vorbestimmten Entladezeitraum entlädt, wenn ein Betrieb des Batteriesystems endet.

4. Batteriesystem nach Anspruch 1, ferner umfassend:
ein erstes Hauptrelais (51), welches zwischen einem ersten Eingangsanschluss einer Leistungseinrichtung (2), welche mit dem Batteriesystem verbunden ist, und positiven Elektroden der Mehrzahl von Batteriepacks (10, 20, 30) geschaltet ist; und
ein zweites Hauptrelais (52), welches zwischen einem zweiten Eingangsanschluss der Leistungseinrichtung (2) und negativen Elektroden der Mehrzahl von Batteriepacks (10, 20, 30) geschaltet ist;
wobei der Kondensator (533), der Widerstand (531) und der Schalter (532) zwischen dem ersten Hauptrelais (51) und dem zweiten Hauptrelais (52) und zwischen der Mehrzahl erster Relais (101, 201, 301) und der Mehrzahl zweiter Relais (102, 202, 302) positioniert sind.

5. Batteriesystem nach Anspruch 4, wobei:
das erste Hauptrelais (51) und das zweite Hauptrelais (52) derart gesteuert werden, dass sie sich in einem offenen Zustand befinden, während eines Zeitraums, in welchem die Diagnose an der Mehrzahl erster Relais (101, 201, 301) und der Mehrzahl zweiter Relais (102, 202, 302) durchgeführt wird.

6. Batteriesystem nach Anspruch 4, ferner umfassend:
einen Verbindungsschalter (534), welcher zwischen einer jeglichen aus einer ersten Verdrahtung (151) und einer zweiten Verdrahtung (152) geschaltet ist, welche den ersten gemeinsamen Knoten (P+) und den zweiten gemeinsamen Knoten (P-) mit der Leistungseinrichtung (2) und dem Kondensator (533) verbinden.

7. Fahrzeug, umfassend:
ein Batteriesystem (1) nach Anspruch 1; und
eine Leistungseinrichtung (2), welche eine Ladung, welche elektrische Leistung von dem Batteriesystem (1) erhält oder ein Ladegerät zum Laden des Batteriesystems ist.

8. Fahrzeug nach Anspruch 7, wobei:
jedes der Mehrzahl von Batterie-Management-Systemen (100, 200, 300) ein Stromerfassungssignal von seinem entsprechenden Stromsensor (103, 203, 303) unter der Mehrzahl von Stromsensoren (103, 203, 303) empfängt und, wenn das empfangene Stromerfassungssignal einen Nullstrom anzeigt, nachdem seine entsprechenden ersten (101, 201, 301) und zweiten (102, 202, 302) Relais gesteuert worden sind, um geschlossen zu sein, diagnostiziert, dass wenigstens eines der entsprechenden ersten (101, 201, 301) und zweiten (102, 202, 302) Relais in einem bleibenden geöffneten Zustand ist.

9. Fahrzeug nach Anspruch 7, wobei:
das Batteriesystem (1) ferner
eine Hauptsteuerungs-IC (40) umfasst, welche den Kondensator (533) durch Einschalten des Schalters (532) für einen vorbestimmten Entladezeitraum entlädt, wenn ein Starten des Fahrzeugs aus ist.

10. Fahrzeug nach Anspruch 7, ferner umfassend:
ein erstes Hauptrelais (51), welches zwischen einem ersten Eingangsanschluss der Leistungseinrichtung (2) und positiven Elektroden der Mehrzahl von Batteriepacks (10, 20, 30) geschaltet ist; und
ein zweites Hauptrelais (52), welches zwischen einem zweiten Eingangsanschluss der Leistungseinrichtung (2) und negativen Elektroden der Mehrzahl von Batteriepacks (10, 20, 30) geschaltet ist;
wobei der Kondensator (533), der Widerstand (531) und der Schalter (532) zwischen dem ersten Hauptrelais (51) und dem zweiten Hauptrelais (52) und zwischen der Mehrzahl erster Relais (101, 201, 301) und der Mehrzahl zweiter Relais (102, 202, 302) positioniert sind.

11. Fahrzeug nach Anspruch 10, wobei:
das Batteriesystem (1)
das erste Hauptrelais (51) und das zweite Hauptrelais (52) derart steuert, dass sie während eines Zeitraums, in welchem eine Diagnose an der Mehrzahl erster Relais (101, 201, 301) und der Mehrzahl zweiter Relais (102, 202, 302) durchgeführt wird, geöffnet sind.

12. Fahrzeug nach Anspruch 7, wobei:
das Batteriesystem (1)
ferner einen Verbindungsschalter (534) umfasst, welcher zwischen einer jeglichen aus einer ersten Verdrahtung (151) und einer zweiten Verdrahtung (152) geschaltet ist, welche den ersten gemeinsamen Knoten (P+) und den zweiten gemeinsamen Knoten (P-) mit der Leistungseinrichtung (2) und dem Kondensator (533) verbinden.

## Revendications

1. Système de batterie (1), comprenant :
une pluralité de blocs-batteries (10, 20, 30), chaque bloc-batterie (10, 20, 30) présentant une électrode positive et une électrode négative ;
un premier nœud commun (P+) et un second nœud commun (P-) ;
une pluralité de premiers relais (101, 201, 301), chaque premier relais (101, 201, 301) étant relié entre l'électrode positive d'un correspondant parmi la pluralité de blocs-batteries (10, 20, 30) et le premier nœud commun (P+) ;
une pluralité de seconds relais (102, 202, 302), chaque second relais (102, 202, 302) étant relié entre l'électrode négative d'un correspondant parmi la pluralité de blocs-batteries (10, 20, 30) et le second nœud commun (P-) ;
un condensateur (533) ayant les deux extrémités reliées entre le premier nœud commun (P+) et le second nœud commun (P-) ;
une résistance (531) et un commutateur (532) reliés en série entre le premier nœud commun (P+) et le second nœud commun (P-) ;
une pluralité de capteurs de courant (103, 203, 303), chaque capteur de courant (103, 203, 303) étant configuré pour détecter un courant circulant à partir d'un correspondant parmi la pluralité de blocs-batteries (10, 20, 30) ; et
une pluralité de systèmes de gestion de batterie, BMS, (100, 200, 300), de bloc, chaque système de gestion de batterie (100, 200, 300) étant associé à un respectif parmi la pluralité de blocs-batteries (10, 20, 30), son premier relais (101, 201, 301) correspondant, son second relais (102, 202, 302) correspondant, et son capteur de courant (103, 203, 303) correspondant ;
dans lequel chaque système de gestion de batterie (100, 200, 300) est configuré pour, après le réveil et la commande de son premier relais (101, 201, 301) correspondant et de son second relais (102, 202, 302) correspondant pour se fermer, déterminer que son premier relais (101, 201, 301) correspondant et son second relais (102, 202, 302) correspondant sont normaux lorsqu'un courant circulant depuis son bloc-batterie (10, 20, 30) correspondant vers le condensateur (533) est détecté par son capteur de courant (103, 203, 303) correspondant.

2. Système de batterie selon la revendication 1, dans lequel :
chacun de la pluralité de systèmes de gestion de batterie (100, 200, 300)
reçoit un signal de détection de courant de son capteur de courant (103, 203, 303) correspondant parmi la pluralité de capteurs de courant (103, 203, 303) et, lorsque le signal de détection de courant reçu indique un courant nul après que son premier relais (101, 201, 301) correspondant et son second relais (102, 202, 302) correspondant ont été commandés pour se fermer, diagnostique qu'au moins l'un de son premier relais (101, 201, 301) correspondant et son second relais (102, 202, 302) correspondant est dans un état bloqué ouvert.

3. Système de batterie selon la revendication 1, comprenant en outre :
un circuit intégré, IC, de commande principal (40) déchargeant le condensateur (533) en mettant le commutateur (532) sous tension pendant une période de décharge prédéterminée lorsqu'un fonctionnement du système de batterie se termine.

4. Système de batterie selon la revendication 1, comprenant en outre :
un premier relais principal (51) relié entre une première borne d'entrée d'un dispositif d'alimentation (2) relié au système de batterie et des électrodes positives de la pluralité de blocs-batteries (10, 20, 30) ; et
un second relais principal (52) relié entre une seconde borne d'entrée du dispositif d'alimentation (2) et des électrodes négatives de la pluralité de blocs-batteries (10, 20, 30) ;
dans lequel le condensateur (533), la résistance (531), et le commutateur (532)
sont positionnés entre le premier relais principal (51) et le second relais principal (52), et entre la pluralité de premiers relais (101, 201, 301) et la pluralité de seconds relais (102, 202, 302).

5. Système de batterie selon la revendication 4, dans lequel :
le premier relais principal (51) et le second relais principal (52)
sont commandés pour être dans un état ouvert pendant une période pendant laquelle le diagnostic est réalisé sur la pluralité de premiers relais (101, 201, 301) et la pluralité de seconds relais (102, 202, 302).

6. Système de batterie selon la revendication 4, comprenant en outre :
un commutateur de liaison (534) relié entre l'un quelconque d'un premier câblage (151) et d'un second câblage (152) reliant le premier nœud commun (P+) et le second nœud commun (P-) au dispositif d'alimentation (2) et au condensateur (533).

7. Véhicule, comprenant :
un système de batterie (1) selon la revendication 1 ; et
un dispositif d'alimentation (2) qui est une charge recevant de l'alimentation du système de batterie (1) ou d'un chargeur pour charger le système de batterie.

8. Véhicule selon la revendication 7, dans lequel :
chacun de la pluralité de systèmes de gestion de batterie (100, 200, 300)
reçoit un signal de détection de courant de son capteur de courant (103, 203, 303) correspondant parmi la pluralité de capteurs de courant (103, 203, 303) et, lorsque le signal de détection de courant reçu indique un courant nul après que son premier relais (101, 201, 301) correspondant et son second relais (102, 202, 302) correspondant ont été commandés pour se fermer, diagnostique qu'au moins l'un du premier relais (101, 201, 301) correspondant et du second relais (102, 202, 302) correspondant est dans un état bloqué ouvert.

9. Véhicule selon la revendication 7, dans lequel :
le système de batterie (1) inclut en outre
un circuit intégré, IC, de commande principal (40) déchargeant le condensateur (533) en mettant le commutateur (532) sous tension pendant une période de décharge prédéterminée lorsque le démarrage du véhicule est désactivé.

10. Véhicule selon la revendication 7, comprenant en outre :
un premier relais principal (51) relié entre une première borne d'entrée du dispositif d'alimentation (2) et des électrodes positives de la pluralité de blocs-batteries (10, 20, 30) ; et
un second relais principal (52) relié entre une second borne d'entrée du dispositif d'alimentation (2) et des électrodes négatives de la pluralité de blocs-batteries (10, 20, 30),
dans lequel le condensateur (533), la résistance (531), et le commutateur (532)
sont positionnés entre le premier relais principal (51) et le second relais principal (52), et entre la pluralité de premiers relais (101, 201, 301) et la pluralité de seconds relais (102, 202, 302).

11. Véhicule selon la revendication 10, dans lequel :
le système de batterie (1)
commande l'ouverture du premier relais principal (51) et du second relais principal (52) pendant une période au cours de laquelle un diagnostic est réalisé sur la pluralité de premiers relais (101, 201, 301) et la pluralité de seconds relais (102, 202, 302).

12. Véhicule selon la revendication 7, dans lequel :
le système de batterie (1)
inclut en outre un commutateur de liaison (534) relié entre l'un quelconque d'un premier câblage (151) et d'un second câblage (152) reliant le premier nœud commun (P+) et le second nœud commun (P-) au dispositif d'alimentation (2) et au condensateur (533).
